# EUROPÄISCHE PATENTSCHRIFT

(11) **EP 3 907 477 B1**
(45) Veröffentlichungstag und Bekanntmachung des Hinweises auf die Patenterteilung: **06.07.2022**
(21) Anmeldenummer: 20173118.9
(22) Anmeldetag: 06.05.2020
(51) Int. Cl.: G01D 5/244, G01D 5/245

(54) **MAGNETISCHE POSITIONSMESSEINRICHTUNG**
MAGNETIC POSITION MEASURING DEVICE
DISPOSITIF MAGNÉTIQUE DE MESURE DE LA POSITION

(43) Veröffentlichungstag der Anmeldung: 10.11.2021
(73) Patentinhaber: Dr. Johannes Heidenhain GmbH, 83301 Traunreut (DE)
(72) Erfinder: SCHNEIDER, Johannes, 83278 Traunstein (DE)

(56) Entgegenhaltungen:
- EP-A2- 0 235 750
- WO-A1-2011/136054
- JP-A- H10 185 507

## Beschreibung

### GEBIET DER TECHNIK

Die vorliegende Erfindung betrifft eine magnetische Positionsmesseinrichtung, die zur Positionsmessung von zwei Objekten geeignet ist, die entlang mindestens einer Messrichtung zueinander beweglich angeordnet sind.

### STAND DER TECHNIK

Magnetische Positionsmesseinrichtungen umfassen üblicherweise einen magnetischen Maßstab, bestehend aus alternierend mit im Rastermaß P angeordneten Maßstabbereichen unterschiedlicher Magnetisierung sowie eine in mindestens einer Messrichtung relativ hierzu bewegliche Abtasteinheit. Das Rastermaß P gibt dabei die Ausdehnung eines Maßstabbereichs entlang der Messrichtung an. Auf Seiten der Abtasteinheit ist u.a. eine Detektoranordnung vorgesehen, die geeignete magnetfeldempfindliche Detektorelemente aufweist. Als Detektorelemente kommen dabei streifenförmig ausgebildete, magnetoresistive dünne Schichten in Betracht, beispielsweise Permalloy-Schichten mit einem anisotropen Magnetwiderstand. Dies bedeutet, dass sich beim Vorhandensein eines äußeren Magnetfelds der elektrische Widerstand in den Detektorelementen ändert. Die in den Detektorelementen resultierende Widerstandsänderung ist hierbei eine Funktion des äußeren Magnetfelds, wobei mit zunehmenden magnetischen Feldstärken die Kennlinien derartiger Detektorelemente Verzerrungen erfahren. Die Verzerrungen der Kennlinie haben dann zur Folge, dass auch die Ausgangssignale der Detektorelemente abhängig von den Amplituden des Maßstabs-Magnetfelds Verzerrungen aufweisen und die Genauigkeit der Positionsmessung negativ beeinflussen. Derartige Verzerrungen seien nachfolgend als Harmonische oder Oberwellen der Messsignal-Grundfrequenz bezeichnet, die sich aus dem Rastermaß P des Maßstabs ergibt.

Zur Beseitigung derartiger Oberwellen in magnetischen Positionsmesseinrichtungen sind bereits eine Reihe von Lösungen bekannt geworden. Dabei wird in der Regel abhängig von der zu filternden Oberwelle eine bestimmte geometrische Anordnung der Detektorelemente in der abtastseitigen Detektoranordnung vorgesehen.

Die JP 10-185507 A schlägt beispielsweise zur Filterung der unerwünschten dritten Harmonischen eine bestimmte Ausbildung einer Detektor-Elementarzelle in der Detektoranordnung vor, die drei streifenförmige, magnetoresistive Detektorelemente umfasst, welche in Messrichtung beabstandet zueinander angeordnet sind; die Längsrichtungen der Detektorelemente sind dabei jeweils senkrecht zur Messrichtung orientiert. Benachbarte Detektorelemente besitzen entlang der Messrichtung einen Abstand von P/8, wobei P das Rastermaß der Maßstabbereiche mit entgegengesetzter Magnetisierung angibt. Das mittlere Detektorelement der Detektor-Elementarzelle weist mit der Länge L1 eine größere Länge auf als die beiden äußeren Detektorelemente, die jeweils die Länge L2 besitzen. Die Länge L2 der äußeren Detektorelemente wird gemäß der JP 10-185507 A jeweils mit L2 = L1/ √2 gewählt. Entlang der Messrichtung beabstandet ist eine zweite, identisch aufgebaute Detektor-Elementarzelle vorgesehen, die zusammen mit der ersten Detektor-Elementarzelle einen ersten Detektorblock bildet. Mit Hilfe des ersten Detektorblocks wird dabei ein erstes periodisches Inkrementalsignal erzeugt; über einen zweiten Detektorblock wird ein zweites periodisches Inkrementalsignal erzeugt, das gegenüber dem ersten Inkrementalsignal um 90° phasenversetzt ist. Der zweite Detektorblock ist senkrecht zur Messrichtung gegenüber dem ersten Detektorblock um einen Betrag versetzt angeordnet, der größer als die Länge L1 ist.

Diese Filtervariante ist zum einen nur auf die Filterung der dritten Harmonischen aus den Messsignalen ausgelegt; mitunter beinhalten die Messsignale jedoch noch höhere Harmonische, die beseitigt werden sollen.

Zum anderen erweist sich der senkrecht zur Streifenrichtung benötigte Versatz der Detektorblöcke zur Erzeugung des ersten und zweiten Inkrementalsignals als nicht vorteilhaft. Liegen beispielsweise Inhomogenitäten in der Materialzusammensetzung im Maßstab vor, so unterscheiden sich lokal die Amplituden des ersten und zweiten Inkrementalsignals, was eine ungenaue Positionserfassung zur Folge hat.

### ZUSAMMENFASSUNG DER ERFINDUNG

Der vorliegenden Erfindung liegt die Aufgabe zugrunde, eine hochgenaue magnetische Positionsmesseinrichtung anzugeben, die eine effektive Filterung mehrerer unerwünschter Harmonischer aus den Ausgangssignalen ermöglicht. Dabei soll über eine möglichst kompakte Ausdehnung der Detektoranordnung eine gute Filterwirkung auch bei vorliegenden Inhomogenitäten im abgetasteten Maßstab gewährleistet sein.

Diese Aufgabe wird erfindungsgemäß durch eine magnetische Positionsmesseinrichtung mit den Merkmalen des Anspruchs 1 sowie durch eine magnetische Positionsmesseinrichtung mit den Merkmalen des Anspruchs 6 gelöst,

Vorteilhafte Ausführungsformen der erfindungsgemäßen magnetischen Positionsmesseinrichtung ergeben sich aus den Maßnahmen, die in den abhängigen Ansprüchen aufgeführt sind.

Die erfindungsgemäße magnetische Positionsmesseinrichtung umfasst einen magnetischen Maßstab sowie eine in mindestens einer Messrichtung relativ hierzu bewegliche Abtasteinheit. Der magnetische Maßstab besitzt im gleichmäßigen Rastermaß P angeordnete Maßstabbereiche mit entgegengesetzt orientierter Magnetisierung, wobei das Rastermaß P die Ausdehnung eines Maßstabbereichs entlang der Messrichtung angibt. Die Abtasteinheit weist mindestens eine erste Detektor-Elementarzelle auf, die drei streifenförmige, magnetoresistive Detektorelemente umfasst, die in Messrichtung beabstandet zueinander angeordnet sind, wobei die Längsrichtungen der Detektorelemente jeweils senkrecht zur Messrichtung orientiert sind. Entlang der Messrichtung benachbarte Detektorelemente in der ersten Detektor-Elementarzelle besitzen einen Abstand Dₓ = P/12. Dabei weist das mittlere Detektorelement entlang seiner Längsrichtung eine Länge L_{b} auf, die größer ist als die Längen Lₐ, L_{c} der beiden äußeren Detektorelemente, wobei die beiden äußeren Detektorelemente dabei jeweils eine Detektorelement-Länge Lₐ = L_{c} = L_{b} / √3 aufweisen. Die Abtasteinheit weist mindestens einen ersten Detektorblock auf, der aus der ersten Detektor-Elementarzelle und einer zweiten Detektor-Elementarzelle besteht, die identisch zur ersten Detektor-Elementarzelle ausgebildet ist, wobei die zweite Detektor-Elementarzelle
- entlang der Messrichtung um den Messrichtungs-Versatzbetrag V_DEₓ = P/6 gegenüber der ersten Detektor-Elementarzelle versetzt angeordnet ist, und
- senkrecht zur Messrichtung um den Transversal-Versatzbetrag V_DE_{y} = L_{b} + Δ1 gegenüber der ersten Detektor-Elementarzelle versetzt angeordnet ist, so dass der erste Detektorblock entlang der Längsrichtung der Detektorelemente eine Detektorblock-Länge L_DB_{y} = 2 • L_{b} + Δ1 besitzt, und wobei Δ1 = [10µm - 100µm] gewählt ist.

Weiterhin ist möglich, dass die Abtasteinheit ferner einen zweiten Detektorblock aufweist, der identisch zum ersten Detektorblock ausgebildet ist, wobei der erste und der zweite Detektorblock zusammen eine erste Detektorgruppe bilden, und wobei der zweite Detektorblock
- entlang der Messrichtung um den Messrichtungs-Versatzbetrag V_DBₓ = P/22 gegenüber dem ersten Detektorblock versetzt angeordnet ist, und
- senkrecht zur Messrichtung um den Transversal-Versatzbetrag V_DB_{y} = L_DB_{y} + Δ2 gegenüber dem ersten Detektorblock versetzt angeordnet ist, und wobei Δ2 = [10µm - 100µm] gewählt ist.

Ferner können die Detektorelemente der ersten Detektorgruppe seriell miteinander verschaltet sein, so dass im Fall der Relativbewegung von Maßstab und Abtasteinheit ein erstes periodisches Teil-Inkrementalsignal über die erste Detektorgruppe erzeugbar ist.

Desweiteren kann vorgesehen sein, dass die Abtasteinheit mindestens drei weitere Detektorgruppen aufweist, die jeweils identisch zur ersten Detektorgruppe ausgebildet sind, wobei
- eine zweite Detektorgruppe entlang der Messrichtung im Abstand Gx = P/4 beabstandet von der ersten Detektorgruppe angeordnet ist, so dass im Fall der Relativbewegung von Maßstab und Abtasteinheit ein zweites periodisches Teil-Inkrementalsignal über die zweite Detektorgruppe erzeugbar ist, das um 90° phasenversetzt gegenüber dem ersten Teil-Inkrementalsignal ist, und
- eine dritte Detektorgruppe entlang der Messrichtung im Abstand Gx = P/4 beabstandet von der zweiten Detektorgruppe angeordnet ist, so dass im Fall der Relativbewegung von Maßstab und Abtasteinheit ein drittes periodisches Teil-Inkrementalsignal über die dritte Detektorgruppe erzeugbar ist, das um 90° phasenversetzt gegenüber dem zweiten Teil-Inkrementalsignal ist und
- eine vierte Detektorgruppe entlang der Messrichtung im Abstand Gx = P/4 beabstandet von der dritten Detektorgruppe angeordnet ist, so dass im Fall der Relativbewegung von Maßstab und Abtasteinheit ein viertes periodisches Teil-Inkrementalsignal über die vierte Detektorgruppe erzeugbar ist, das um 90° phasenversetzt gegenüber dem dritten Teil-Inkrementalsignal ist.

Hierbei ist möglich, dass
- die erste und dritte Detektorgruppe derart miteinander verschaltet sind, dass aus dem ersten und dritten Teil-Inkrementalsignal ein erstes periodisches Inkrementalsignal erzeugbar ist, und
- die zweite und vierte Detektorgruppe derart miteinander verschaltet sind, dass aus dem zweiten und vierten Teil-Inkrementaisignal ein zweites periodisches Inkrementalsignal erzeugbar ist, das gegenüber dem ersten Inkrementalsignal um 90° phasenversetzt ist.

Die erfindungsgemäße magnetische Positionsmesseinrichtung umfasst einen magnetischen Maßstab sowie eine in mindestens einer Messrichtung relativ hierzu bewegliche Abtasteinheit. Der magnetische Maßstab besitzt im gleichmäßigen Rastermaß P angeordnete Maßstabbereiche mit entgegengesetzt orientierter Magnetisierung, wobei das Rastermaß P die Ausdehnung eines Maßstabbereichs entlang der Messrichtung angibt. Die Abtasteinheit weist mindestens eine erste Detektor-Elementarzelle auf, die drei streifenförmige, magnetoresistive Detektorelemente umfasst, die in Messrichtung beabstandet zueinander angeordnet sind, wobei die Längsrichtungen der Detektorelemente jeweils senkrecht zur Messrichtung orientiert sind. Entlang der Messrichtung benachbarte Detektorelemente in der ersten Detektor-Elementarzelle besitzen einen Abstand Dx = P/12. Die Abtasteinheit weist mindestens einen ersten Detektorblock auf, der aus der ersten Detektor-Elementarzelle und einer zweiten Detektor-Elementarzelle besteht, wobei die zweite Detektor-Elementarzelle entlang der Messrichtung um den Messrichtungs-Versatzbetrag V_DEₓ = P/6 versetzt gegenüber der ersten Detektor-Elementarzelle angeordnet ist, und wobei ein Detektorelement sowohl Bestandteil der ersten und der zweiten Detektor-Elementarzelle ist, so dass der erste Detektorblock fünf Detektorelemente umfasst. Dabei weisen die mittleren Detektorelemente der beiden Detektor-Elementarzellen jeweils die gleiche Länge L_{b} = L_{b}' aufweisen. Die äußersten Detektorelemente der beiden Detektor-Elementarzellen weisen jeweils die gleiche Länge Lₐ = Lₐ' aufweisen und das Detektorelement, welches sowohl Bestandteil der ersten und zweiten Detektor-Elementarzelle ist, weist entlang seiner Längsrichtung eine Detektorelement-Länge L₃ = 2 • Lₐ = 2 • L_{b}/√3 auf. Vorzugsweise besitzt hierbei der erste Detektorblock entlang der Längsrichtung der Detektorelemente eine Detektorblock-Länge L_DB_{y}'= 2 • L_{b} + Δ1', wobei Δ1' = [10µm - 100µm] gewählt ist.

### Desweiteren ist dabei vorgesehen, dass

### Fortsetzung: Ursprüngliche Seite 7

- das Detektorelement, welches sowohl Bestandteil der ersten und zweiten Detektor-Elementarzelle ist, symmetrisch zu einer mittigen Symmetrielinie des ersten Detektorblocks angeordnet ist, und
- die beiden weiteren Detektorelemente der ersten Detektor-Elementarzelle im Bereich zwischen Δ1'/2 und L_DB_{y}'/2 beabstandet auf einer Seite der Symmetrielinie angeordnet sind, und
- die beiden weiteren Detektorelemente der zweiten Detektor-Elementarzelle im Bereich zwischen Δ1'/2 und L_DB_{y}'/2 auf der gegenüberliegenden Seite der Symmetrielinie angeordnet sind.

Darüber hinaus kann die Abtasteinheit ferner einen zweiten Detektorblock aufweisen, der identisch zum ersten Detektorblock ausgebildet ist, wobei der erste und der zweite Detektorblock zusammen eine erste Detektorgruppe bilden und wobei der zweite Detektorblock
- entlang der Messrichtung um den Messrichtungs-Versatzbetrag V_DBₓ'= P/22 gegenüber dem ersten Detektorblock versetzt angeordnet ist, und
- senkrecht zur Messrichtung um den Transversal-Versatzbetrag V_DB_{y} = L_DB_{y}'+ Δ2' gegenüber dem ersten Detektorblock versetzt angeordnet ist, und wobei Δ2' = [10µm - 100µm] gewählt ist.

Mit Vorteil sind jeweils die Detektorelemente einer Detektorgruppe seriell miteinander verschaltet.

Desweiteren kann vorgesehen sein, dass die Detektorelemente als anisotrope magnetoresistive Sensoren ausgebildet sind.

In der erfindungsgemäßen magnetischen Positionsmesseinrichtung kann basierend auf der Ausbildung einer ersten Detektor-Elementarzelle eine Vorrichtung aufgebaut werden, die auch eine Filterung bzw. Unterdrückung mehrerer unerwünschter Harmonischer in den Ausgangssignalen sicherstellt, beispielsweise die gleichzeitige Filterung der 3., 5., 7., 9. und 11. Harmonischen. Dies kann zudem durch eine äußerst kompakte räumliche Ausdehnung der hierzu erforderlichen Strukturen in der abtastseitigen Detektoranordnung erreicht werden. Dadurch lässt sich der Einfluss eventueller Maßstabs-Inhomogenitäten auf die gewünschte Filterwirkung erheblich verringern.

Weitere Einzelheiten und Vorteile der vorliegenden Erfindung seien anhand der nachfolgenden Beschreibung von Ausführungsbeispielen der erfindungsgemäßen Vorrichtung in Verbindung mit den Figuren erläutert.

### KURZE BESCHREIBUNG DER ZEICHNUNGEN

Es zeigt
- Figur 1: eine schematische Darstellung eines ersten Ausführungsbeispiels der erfindungsgemäßen magnetischen Positionsmesseinrichtung, die zur Erfassung rotatorischer Relativbewegungen geeignet ist;
- Figur 2: eine schematische Darstellung eines zweiten Ausführungsbeispiels der erfindungsgemäßen magnetischen Positionsmesseinrichtung, die zur Erfassung linearer Relativbewegungen geeignet ist;
- Figur 3: eine schematische Darstellung zur Erläuterung des Aufbaus einer Detektor-Elementarzelle in einem Ausführungsbeispiel einer Abtasteinheit der erfindungsgemäßen magnetischen Positionsmesseinrichtung;
- Figur 4: ein schematische Darstellung zur Erläuterung des Aufbaus einer Detektorblocks in einem Ausführungsbeispiel einer Abtasteinheit der erfindungsgemäßen magnetischen Positionsmesseinrichtung;
- Figur 5: ein schematische Darstellung zur Erläuterung des Aufbaus einer Detektorgruppe in einem Ausführungsbeispiel einer Abtasteinheit der erfindungsgemäßen magnetischen Positionsmesseinrichtung;
- Figur 6: ein schematische Darstellung zur Erläuterung einer Anordnung mit mehreren Detektorgruppen in einem Ausführungsbeispiel einer Abtasteinheit der erfindungsgemäßen magnetischen Positionsmesseinrichtung;
- Figur 7: ein schematische Darstellung zur Erläuterung des Aufbaus eines Detektorblocks in einem weiteren Ausführungsbeispiel einer Abtasteinheit der erfindungsgemäßen magnetischen Positionsmesseinrichtung;
- Figur 8: ein schematische Darstellung zur Erläuterung des Aufbaus einer Detektorgruppe im Ausführungsbeispiel der Figur 7.

### BESCHREIBUNG DER AUSFÜHRUNGSFORMEN

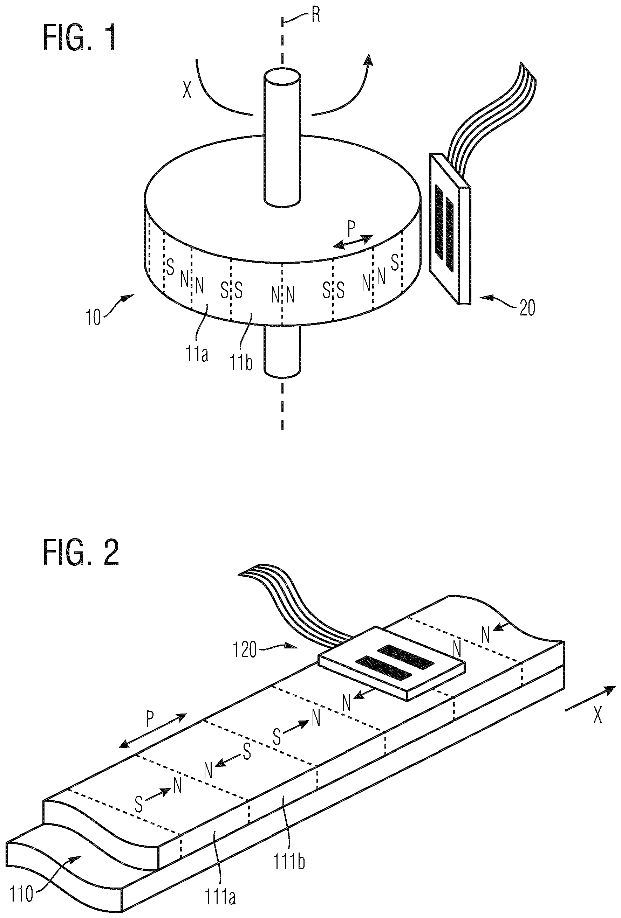

Die Figuren 1 und 2 veranschaulichen in stark schematisierter Form ein erstes und zweites Ausführungsbeispiel der erfindungsgemäßen magnetischen Positionsmesseinrichtung.

Die in Figur 1 dargestellte Variante dient hierbei zur Erfassung der Relativposition zweier - nicht gezeigter - Objekte, die rotatorisch um eine Rotationsachse R zueinander beweglich angeordnet sind. Ein erstes Objekt ist dabei mit dem magnetischen Maßstab 10 der erfindungsgemäßen magnetischen Positionsmesseinrichtung verbunden, ein zweites Objekt mit der Abtasteinheit 20 der Positionsmesseinrichtung. Maßstab 10 und Abtasteinheit 20 sind entlang der Messrichtung x relativ zueinander um die Rotationsachse R beweglich, wobei sich die Messrichtung x hier entlang eines Kreisrings um die Rotationsachse R erstreckt.

Bei den mit Maßstab 10 und Abtasteinheit 20 verbundenen Objekten kann es sich z.B. um zwei zueinander um die Rotationsachse R bewegliche Maschinenkomponenten handeln, deren Relativposition mit Hilfe der erfindungsgemäßen magnetischen Positionsmesseinrichtung zu erfassen ist. Hierzu erzeugt die Positionsmesseinrichtung positionsabhängige Abtastsignale in Form von periodischen Inkrementalsignalen, die von einer - nicht dargestellten - Folgeelektronik weiterverarbeitbar sind.

Der magnetische Maßstab 10 besitzt Maßstabbereiche 11a, 11b mit entgegengesetzt orientierter Magnetisierung, die im gleichmäßigen Rastermaß P entlang der Messrichtung x auf der äußeren Umfangsfläche eines trommelförmigen Trägerkörpers angeordnet sind. Der trommelförmige Trägerkörper ist dabei drehbar um die Rotationsachse R angeordnet.. Das Rastermaß P gibt die Ausdehnung eines Maßstabbereichs 11a, 11b entlang der Messrichtung x an; sowohl die Maßstabbereiche 11a als auch die Maßstabbereiche 11b weisen somit die identische Ausdehnung entlang der Messrichtung x auf. Wie aus Figur 1 ersichtlich, sind die Maßstabbereiche 11a, 11b derart angeordnet, dass benachbarte Maßstabbereiche 11a, 11b im Grenzbereich jeweils eine entgegengesetzt orientierte Magnetisierung bzw. die gleichen magnetischen Pole besitzen. Bei benachbarten Maßstabbereichen 11a, 11b liegen sich demzufolge immer magnetische Nord- oder Südpole gegenüber. Die Maßstabperiodizität λ ergibt sich bei einem derart ausgebildeten Maßstab 10 demzufolge gemäß λ = 2 • P.

Über den Maßstab 10 wird entlang der Messrichtung x benachbart zum Maßstab 10 damit ein periodisch moduliertes Magnetfeld erzeugt, das von der Abtasteinheit 20 abgetastet wird. In einem möglichen Ausführungsbeispiel ist das Rastermaß der Maßstabbereiche 11a, 11b gemäß P = 395µm gewählt.

Auf Seiten der Abtasteinheit 20 ist eine Detektoranordnung mit mehreren magnetoresistiven Detektorelementen zur Erzeugung von positionsabhängigen Abtastsignalen bzw. Inkrementalsignalen vorgesehen. Die Detektoranordnung ist in Figur 1 nur schematisch angedeutet und wird im Verlauf der weiteren Beschreibung noch im Detail erläutert. Im vorliegenden Ausführungsbeispiel ist die Abtasteinheit 20 gegenüber dem rotierenden, trommelförmigen Trägerköper mit dem Maßstab 10 stationär angeordnet.

Als magnetoresistive Detektorelemente fungieren in der Abtasteinheit 20 in diesem Ausführungsbeispiel anisotrope magnetoresistive Sensoren, die auch als sog. AMR-Sensoren bekannt sind. Diese bestehen aus streifenförmig ausgebildeten, dünnen Schichten aus einer NiFe-Legierung wie z.B. Permalloy, deren elektrischer Widerstand sich beim Vorhandensein eines äußeren Magnetfelds ändert. Aufgrund des periodisch modulierten Maßstab-Magnetfelds können bei einer Relativbewegung von Maßstab 10 und Abtasteinheit 20 somit positionsabhängige, periodische Abtastsignale über die Detektoranordnung der Abtasteinheit 20 erzeugt werden, die eine Signalperiode SP = P besitzen.

Die mit Hilfe der erfindungsgemäßen magnetischen Positionsmesseinrichtung erzeugten Abtastsignale werden an eine ebenfalls nicht in den Figuren gezeigte Folgeelektronik übermittelt, die diese je nach Anwendung weiterverarbeitet. Beispielsweise kann es sich hierbei um eine übergeordnete Maschinensteuerung handeln, die die Relativbewegung der beiden zueinander beweglichen Maschinenkomponenten steuert.

Eine zweite Variante einer erfindungsgemäßen magnetischen Positionsmesseinrichtung ist in Figur 2 gezeigt. Diese dient zur Erfassung der Relativposition zweier - ebenfalls nicht gezeigter - Objekte, die hier entlang der linearen Messrichtung x zueinander verschiebbar angeordnet sind. Ein erstes Objekt ist wiederum mit dem magnetischen Maßstab 110 der erfindungsgemäßen magnetischen Positionsmesseinrichtung verbunden, ein zweites Objekt mit der Abtasteinheit 120 der Positionsmesseinrichtung.

Der Maßstab 110 erstreckt sich hier entlang der linearen Messrichtung x und weist ebenfalls Maßstabbereiche 111a, 111b mit entgegengesetzt orientierter Magnetisierung auf. Die Maßstabbereiche 111a, 111b sind wie in der rotatorischen Variante im gleichmäßigen Rastermaß P entlang der Messrichtung x auf einem geeigneten Trägerkörper angeordnet.

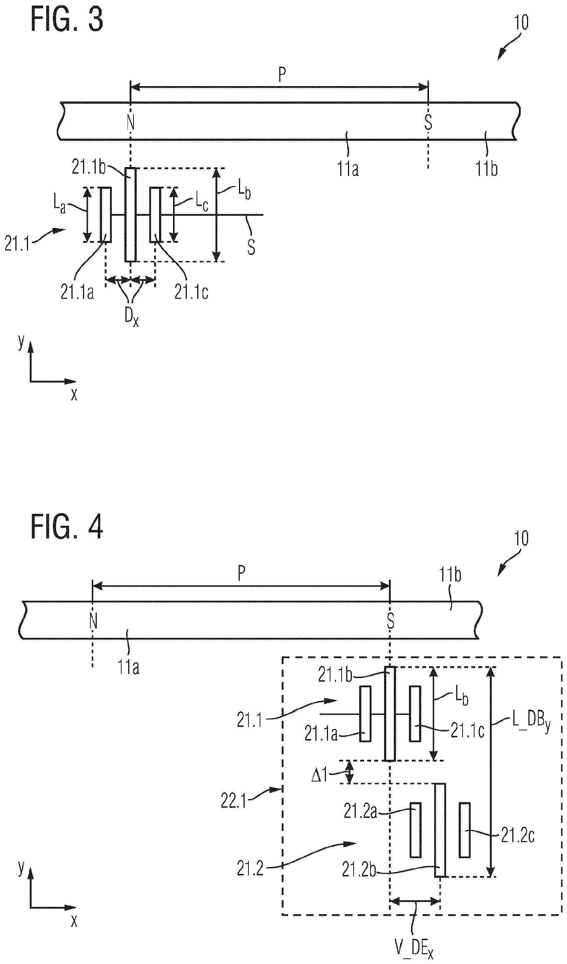

Auch in diesem Beispiel ist die konkrete Ausbildung der Abtasteinheit 120 und insbesondere die Detektoranordnung mit den magnetoresistiven Detektorelementen nicht aus der Figur erkennbar. Mögliche Varianten der Abtasteinheit 120 der erfindungsgemäßen magnetischen Positionsmesseinrichtung werden im Gefolge anhand der Figuren 3 - 6 im Detail erläutert; diese können sowohl in rotatorischen als auch in linearen Ausführungsformen der erfindungsgemäßen Vorrichtung zum Einsatz kommen.

Figur 3 zeigt in schematischer Form eine Draufsicht auf eine erste Detektor-Elementarzelle 21.1 in der Detektoranordnung einer Abtasteinheit, die benachbart zu einem Abschnitt des darüber abgetasteten magnetischen Maßstabs 10 dargestellt ist. Die Detektor-Elementarzelle 21.1 umfasst gemäß diesem Ausführungsbeispiel drei streifenförmige, magnetoresistive Detektorelemente 21.1a, 21.1b, 21.1c, die in Messrichtung x beabstandet zueinander angeordnet sind. Die Detektorelemente 21.1a - 21.1c sind rechteckförmig ausgebildet, wobei sich deren parallel orientierte Längsrichtungen y jeweils senkrecht zur Messrichtung x erstrecken.

Der entlang der Messrichtung x vorgesehene Abstand Dₓ zwischen benachbarten Detektorelementen 21.1a - 21.1c wird in der erfindungsgemäßen magnetischen Positionsmesseinrichtung abhängig vom Rastermaß P der Maßstabbereiche 11a, 11b auf dem Maßstab 10 gewählt und beträgt Dₓ = P/12.

Wie aus Figur 3 ersichtlich, weist das mittlere Detektorelement 21.1b entlang seiner Längsrichtung y eine Länge L_{b} auf, die größer als die Längen Lₐ, L_{c} der beiden äußeren Detektorelemente 21.1a, 21.1c gewählt ist. Die Längen Lₐ, L_{c} der beiden äußeren Detektorelemente 21.1a, 21.1c sind identisch gewählt und weisen jeweils die Längen Lₐ = L_{c} = L_{b} / √3 auf.

In einem möglichen Ausführungsbeispiel wird bei einem Rastermaß P = 395µm die Länge des L_{b} des mittleren Detektorelements 21.1b gemäß L_{b} = 80µm gewählt, womit sich für die Längen Lₐ, L_{c} der beiden äußeren Detektorelemente 21.1a, 21.1c gemäß der vorstehend erwähnten Beziehung Lₐ = L_{c} = 46,19µm ergibt.

Über eine derartige Ausbildung der ersten Detektor-Elementarzelle 21.1 resultiert eine definierte Filterwirkung auf die in den periodischen Abtastsignalen enthaltenen Harmonischen. So lassen sich mit einer derart ausgebildeten Detektor-Elementarzelle 21.1 die 5. und 7. Harmonische aus den Abtastsignalen herausfiltern, die im Fall einer Relativbewegung zwischen Maßstab 10 und Abtasteinheit bei der Abtastung des magnetischen Maßstabs 10 resultieren.

Grundsätzlich ist in diesem Beispiel einer ersten Detektor-Elementarzelle 21.1 nicht zwingend erforderlich, dass die beiden äußeren Detektorelemente 21.1a, 21.1c wie im Beispiel der Figur 3 vorgesehen, mittig in Bezug auf eine Symmetrielinie S des mittleren Detektorelements 21.1b angeordnet werden. Es ist alternativ auch möglich, dass diese Detektorelemente 21.1a, 21.1c entlang ihrer Längsrichtung y in einem Bereich verschoben angeordnet werden, der durch die Länge L_{b} des mittleren Detektorelements 21.1b vorgegeben ist.

Um neben der 5. und 7. Harmonischen noch weitere Harmonische aus den Abtastsignalen zu entfernen, kann die aus der ersten Detektor-Elementarzelle 21.1 bestehende Detektoranordnung in der Abtasteinheit geeignet modifiziert bzw. erweitert werden. Eine Möglichkeit zur zusätzlichen Filterung der 3. und 9. Harmonischen wird nachfolgend anhand der schematischen Darstellung in Figur 4 erläutert.

In diesem Ausführungsbeispiel ist vorgesehen, dass die Detektoranordnung in der Abtasteinheit neben der ersten Detektor-Elementarzelle 21.1 noch eine zweite Detektor-Elementarzelle 21.2 aufweist. Die zweite Detektor-Elementarzelle 21.2 ist grundsätzlich identisch zur ersten Detektor-Elementarzelle 21.1 ausgebildet, umfasst also analog zur ersten Detektor-Elementarzelle 21.1 ebenfalls drei Detektorelemente 21.2a - 21.2c, deren Längen entlang der Richtung y sowie deren gegenseitige Relativanordnung entlang der Messrichtung analog zur ersten Detektor-Elementarzelle 21.1 gewählt sind.

Die zweite Detektor-Elementarzelle 21.2 ist in einer bestimmten Relativposition zur ersten Detektor-Elementarzelle 21.1 in der Detektoranordnung angeordnet. So ist die zweite Detektor-Elementarzelle 21.2 entlang der Messrichtung x um den Messrichtungs-Versatzbetrag V_DEₓ = P/6 gegenüber der ersten Detektor-Elementarzelle 21.1 versetzt angeordnet. Ferner ist vorgesehen, dass die zweite Detektor-Elementarzelle 21.2 senkrecht zur Messrichtung x, also entlang der y-Richtung, um den Transversal-Versatzbetrag V_DE_{y} = L_{b} + Δ1 gegenüber der ersten Detektor-Elementarzelle 21.1 versetzt angeordnet ist. Die Größe Δ1 wird dabei vorzugsweise in einem Bereich Δ1 = [10µm - 100µm] gewählt.

Über die beiden Detektor-Elementarzellen 21.1, 21.2 wird damit ein erster Detektorblock 22.1 ausgebildet. Der erste Detektorblock 22.1 besitzt hierbei entlang der Längsrichtung y der Detektorelemente 21.1a - 21.1c, 21.2a - 21.2c eine Detektorblock-Länge L_DB_{y} = 2 • L_{b} + Δ1.

Wird die Größe Δ1 in einem Ausführungsbeispiel etwa Δ1 = 80µm gewählt, so resultiert mit L_{b} = 80µm dann eine Detektorblock-Länge L_DB_{y} = 240µm entlang der y-Richtung. Damit kann also eine Filterung unerwünschter Harmonischer aus den erzeugten Abtastsignalen mittels einer Detektoranordnung erfolgen, die entlang der y-Richtung sehr kompakt ausgebildet ist. Wenn typische Ausdehnungen eventueller Maßstabs-Inhomogenitäten in der Größenordnung von ca. 300µm vorliegen, kann mittels einer derartig ausgebildeten Detektoranordnung somit der Einfluss eventueller Maßstabs-Inhomogenitäten auf die gewünschte Filterwirkung erheblich verringert werden

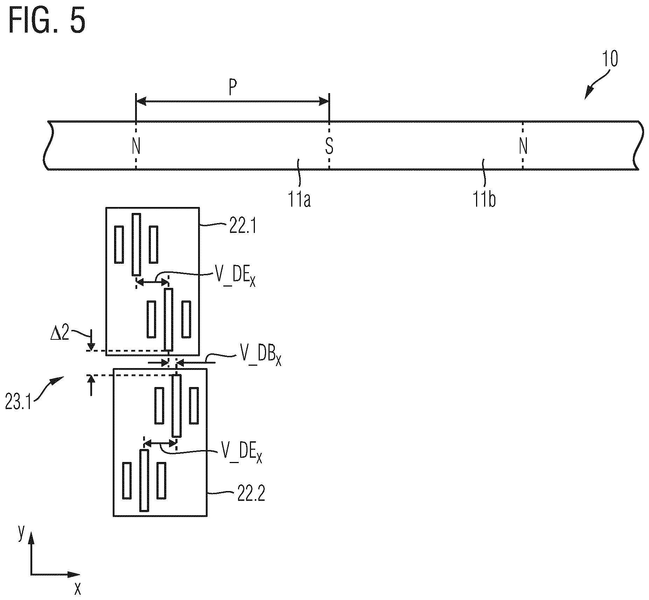

Soll über die Filterung der 3., 5., 7. und 9. Harmonischen hinaus noch die 11. Harmonische aus den Abtastsignalen herausgefiltert werden, so kann die aus dem ersten Detektorblock 22.1 bestehende Detektoranordnung gemäß Figur 4 in der Abtasteinheit nochmals erweitert werden. Eine Möglichkeit zur zusätzlichen Filterung der 11 Harmonischen wird nachfolgend anhand der schematischen Darstellung in Figur 5 erläutert.

In diesem Ausführungsbeispiel ist vorgesehen, dass die Detektoranordnung in der Abtasteinheit neben dem ersten Detektorblock 22.1 noch einen zweiten Detektorblock 22.2 aufweist. Der zweite Detektorblock 22.2 ist grundsätzlich identisch zum ersten Detektorblock 22.1 ausgebildet und besteht ebenfalls aus zwei Detektor-Elementarzellen, die eine bestimmte Relativanordnung zueinander aufweisen.

Der zweite Detektorblock 22.2 wird in der Detektoranordnung in einer bestimmten Relativanordnung zum ersten Detektorblock 22.1 platziert. So ist zum einen vorgesehen, dass der zweite Detektorblock entlang der Messrichtung x um den Messrichtungs-Versatzbetrag V_DBₓ = P/22 gegenüber dem ersten Detektorblock 22.1 versetzt angeordnet ist. Zum anderen ist der zweite Detektorblock 22.2 senkrecht zur Messrichtung x um den Transversal-Versatzbetrag V_DB_{y} = L_DB_{y} + Δ2 gegenüber dem ersten Detektorblock 22.1 versetzt angeordnet. Die Größe Δ2 wird dabei vorzugsweise in einem Bereich Δ2 = [10µm - 100µm] gewählt.

Über die beiden Detektorblöcke 22.1, 22.2 wird in diesem Ausführungsbeispiel eine erste Detektorgruppe 23.1 ausgebildet, die zur Filterung der 3., 5., 7., 9. und 11. Harmonischen aus den Abtastsignalen geeignet ist.

Sämtliche Detektorelemente der ersten Detektorgruppe 23.1 werden in der Abtasteinheit seriell miteinander verschaltet. Im Fall der Relativbewegung von Maßstab 10 und Abtasteinheit kann damit ein erstes periodisches Teil-Inkrementalsignal erzeugt werden, das nachfolgend mit S_0 bezeichnet wird.

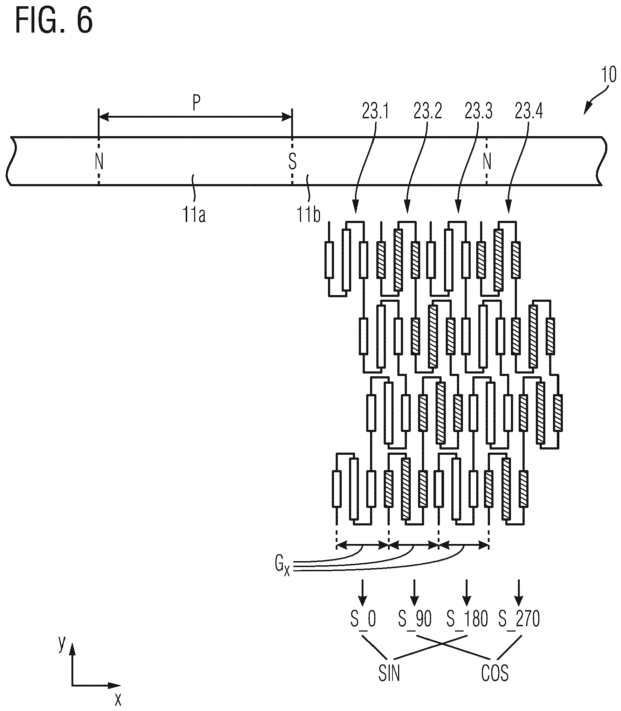

Um für eine der erfindungsgemäßen magnetischen Positionsmesseinrichtung nachgeordnete Folgeelektronik um 90° phasenversetzte Inkrementalsignale bereitstellen zu können, kann die Detektoranordnung aus Figur 5 nochmals erweitert werden. Eine entsprechende Variante einer derartigen Detektoranordnung ist in Figur 6 schematisch dargestellt. In dieser Figur sind zudem die Verbindungsleitungen gezeigt, die innerhalb einer Detektorgruppe jeweils die Detektorelemente seriell miteinander verbinden; diese können z.B. als Kupfer-Leitungen zwischen den Permalloy-Schichtstreifen der Detektorelemente ausgebildet sein.

Die in Figur 6 gezeigte Detektoranordnung umfasst neben der ersten Detektorgruppe 23.1 gemäß dem Beispiel aus Figur 5 noch drei weitere Detektorgruppen 23.2 - 23.4, die jeweils grundsätzlich identisch zur ersten Detektorgruppe 23.1 ausgebildet sind.

Hierbei ist eine zweite Detektorgruppe 23.2 entlang der Messrichtung x im Abstand Gx = P/4 beabstandet von der ersten Detektorgruppe 23.1 angeordnet. Im Fall der Relativbewegung von Maßstab 10 und Abtasteinheit ist über die zweite Detektorgruppe 23.2 damit ein zweites periodisches Teil-Inkrementalsignal S_90 erzeugbar, das um 90° phasenversetzt gegenüber dem ersten Teil-Inkrementalsignal S_0 ist.

Eine dritte Detektorgruppe 23.3 ist ferner entlang der Messrichtung x im Abstand Gx = P/4 beabstandet von der zweiten Detektorgruppe 23.2 angeordnet, worüber im Fall der Relativbewegung von Maßstab 10 und Abtasteinheit ein drittes periodisches Teil-Inkrementalsignal S_180 erzeugbar ist, das um 90° phasenversetzt gegenüber dem zweiten Teil-Inkrementalsignal S_90 ist.

Eine vierte Detektorgruppe 23.4 ist schließlich entlang der Messrichtung x im Abstand Gx = P/4 beabstandet von der dritten Detektorgruppe 23.3 angeordnet, um darüber im Fall der Relativbewegung von Maßstab 10 und Abtasteinheit ein viertes periodisches Teil-Inkrementalsignal S_270 über die vierte Detektorgruppe 23.4 zu erzeugen, das um 90° phasenversetzt gegenüber dem dritten Teil-Inkrementalsignal S_180 ist.

Um aus den vier derart erzeugten Teil-Inkrementalsignalen S_0, S_90, S_180, S_270 die seitens der Folgeelektronik erforderlichen zwei periodischen Inkrementalsignale mit 90° Phasenversatz zu erzeugen, kann weiterhin vorgesehen sein, dass zum Einen die erste und dritte Detektorgruppe 23.1, 23.3 über eine Halbbrücke derart miteinander verschaltet werden, dass aus dem ersten und dritten Teil-Inkrementalsignal S_0, S_180 das erste periodische Inkrementalsignal SIN erzeugbar ist. Zum Anderen würde in diesem Fall die zweite und vierte Detektorgruppe 23.2, 23.4 über eine weitere Halbbrücke so miteinander verschaltet werden, dass aus dem zweiten und vierten Teil-Inkrementalsignal S_90, S_270) das zweite periodische Inkrementalsignal COS erzeugbar ist, das gegenüber dem ersten Inkrementalsignal SIN um 90° phasenversetzt ist. Die entsprechende Verschaltung der Detektorelemente ist in Figur 6 dabei nicht im Detail gezeigt, sondern lediglich schematisiert angedeutet.

Alternativ hierzu ist die Erzeugung der Inkrementalsignale SIN, COS auch aus Vollbrücken möglich, die aus jeweils zwei zueinander parallel geschalteten Halbbrücken bestehen. Zur Bildung der Vollbrücken sind vier weitere Detektorgruppen (23.1', 23.2', 23.3' und 23.4') vorgesehen, die identisch zur ersten bis vierten Detektorgruppe gemäß dem erläuterten Beispiel ausgebildet und entlang der Messrichtung x um das Rastermaß P versetzt gegenüber den ersten vier Detektorgruppen angeordnet sind. Das erste Inkrementalsignal SIN resultiert dann aus der Vollbrücken-Verschaltung der Gruppen 23.1, 23.3, 23.1' und 23.3'. Das zweite um 90° phasenversetzte Inkrementalsignal COS resultiert aus der Vollbrücken-Verschaltung der Gruppen 23.2, 23.4, 23.2' und 23.4'.

Eine derartige Detektoranordnung kann ferner in eine Matrix aus mehreren Detektorgruppen erweitert werden, die aus in Messrichtung x angeordneten Spalten mehrerer Detektorgruppen sowie in y-Richtung angeordneten Zeilen mit mehreren Detektorgruppen besteht. Beispielsweise kann hierzu etwa eine Matrix aus acht Spalten und vier Zeilen von Detektorgruppen ausgebildet werden. Über eine solche Detektoranordnung lässt sich eine nochmals verbesserte Mittelung der erzeugten Abtastsignale erreichen, ferner können darüber resultierende Fehler aus dem nicht-perfekten Anbau der erfindungsgemäßen Positionsmesseinrichtung in der jeweiligen Applikation minimiert werden.

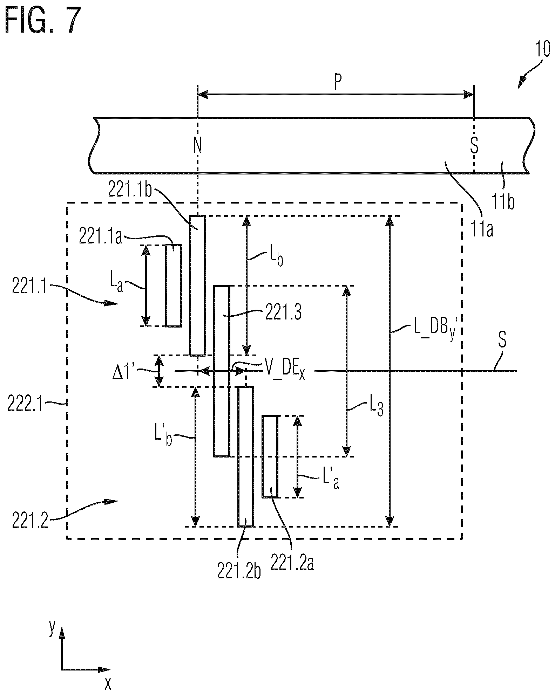

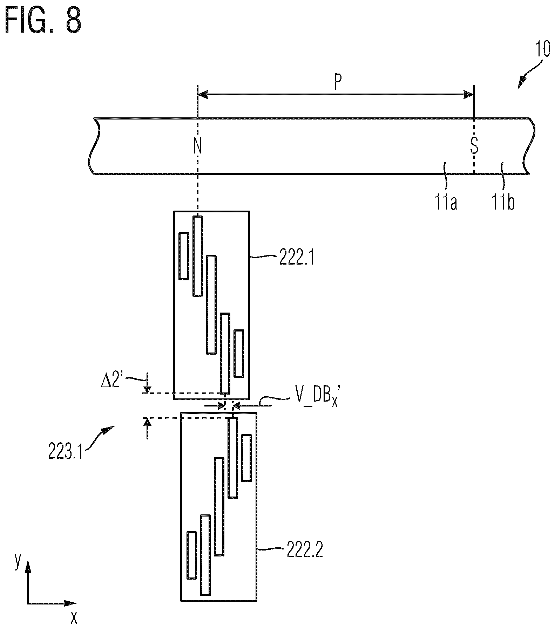

Ein weiteres Ausführungsbeispiel zur alternativen Ausbildung geeigneter Detektorblöcke bzw. Detektorgruppen in der Detektoranordnung der Abtasteinheit einer erfindungsgemäßen Positionsmesseinrichtung werden nachfolgend anhand der Figuren 7 und 8 erläutert; dabei wird i.w. auf die maßgeblichen Unterschiede zu den bislang erläuterten Varianten eingegangen.

In Figur 7 ist eine Möglichkeit zur Ausbildung eines ersten Detektorblocks 222.1 aus zwei Detektor-Elementarzellen 221.1, 221.2 dargestellt, wobei die zweite Detektor-Elementarzelle 221.2 entlang der Messrichtung x um den Messrichtungs-Versatzbetrag V_DEₓ = P/6 versetzt gegenüber der ersten Detektor-Elementarzelle 221.1 angeordnet ist. Ferner ist hier vorgesehen, dass ein Detektorelement 221.3 sowohl Bestandteil der ersten und der zweiten Detektor-Elementarzelle 221.1, 221.2 ist. Wie aus der Figur ersichtlich, handelt es sich dabei in der ersten Detektor-Elementarzelle 222.1. um das von links aus dritte Detektorelement bzw. in der zweiten Detektor-Elementarzelle um das von links aus erste Detektorelement. Daneben umfassen die erste und zweite Detektor-Elementarzelle 221.1, 221.2 jeweils noch zwei weitere Detektorelemente 221.1a, 221.1b bzw. 221.2a, 221.2b. Somit weist der in Figur 7 gezeigte erste Detektorblock 222.1 insgesamt fünf Detektorelemente 221.1a, 221.1b, 221.3, 221.2a, 221.2b auf.

Die benachbarten Detektorelemente einer Elementarzelle 221.1, 221.2 besitzen wie im obigen Beispiel entlang der Messrichtung x jeweils einen Abstand Dₓ = P/12.

In den beiden Detektor-Elementarzellen 221.1, 221.2 weisen die mittleren Detektorelemente 221.1b, 221.2b jeweils die gleiche Länge Lb = L_{b}' auf; ebenso besitzen die äußersten Detektorelemente 221.1a, 221.2a in den beiden Detektor-Elementarzellen 221.1, 221.2 jeweils die gleiche Länge Lₐ = La'.

Dasjenige Detektorelement 221.3, welches sowohl Bestandteil der ersten und zweiten Detektor-Elementarzelle 221.1, 222.2 ist, besitzt im dargestellten Ausführungsbeispiel die Länge L₃ = 2 • Lₐ = 2 • L_{b}/√3.

Für den in Figur 7 gezeigten ersten Detektorblock 221.1 ergibt sich damit entlang der Längsrichtung y der Detektorelemente 221.1a, 221.1b, 221.3, 221.2a, 221.2b eine Detektorblock-Länge L_DB_{y}'= 2 • L_{b} + Δ1'; dabei wird Δ1' = [10µm - 100µm] gewählt.

Wie desweiteren aus Figur 7 ersichtlich, ist das Detektorelement 221.3, welches sowohl Bestandteil der ersten und zweiten Detektor-Elementarzelle 221.1, 221.2 ist, symmetrisch zu einer mittigen Symmetrielinie S des ersten Detektorblocks 221.1 angeordnet. Die beiden weiteren Detektorelemente 221.1a, 221.1b der ersten Detektor-Elementarzelle 221.1 sind ferner im Bereich zwischen Δ1'/2 und L_DB_{y}'/2 beabstandet auf einer Seite der Symmetrielinie S angeordnet. Die beiden weiteren Detektorelemente 221.2a, 221.2b der zweiten Detektor-Elementarzelle 221.2 sind im Bereich zwischen Δ1'/2 und L_DB_{y}'/2 auf der gegenüberliegenden Seite der Symmetrielinie S angeordnet.

Mit Hilfe eines derart ausgebildeten ersten Detektorblocks 221.1 lassen sich aus den periodischen Abtastsignalen die 3., 5., 7. und 9. Harmonische herausfiltern. Soll darüber hinaus auch noch die 11. Harmonische gefiltert werden, so kann die Detektoranordnung analog zum obigen Beispiel um einen weiteren, zweiten Detektorblock 222.2 ergänzt werden wie dies in Figur 8 schematisiert gezeigt ist. Der zweite Detektorblock 222.2 ist prinzipiell identisch zum ersten Detektorblock 222.1 ausgebildet; er bildet zusammen mit dem ersten Detektorblock 222.1 wiederum eine erste Detektorgruppe 223.1, die zur Erzeugung eines ersten Teil-Inkrementalsignals geeignet ist.

Der zweite Detektorblock 222.2 ist entlang der Messrichtung x um den Messrichtungs-Versatzbetrag V_DBₓ'= P/22 gegenüber dem ersten Detektorblock 222.1 versetzt angeordnet ist. Senkrecht zur Messrichtung x ist der zweite Detektorblock 222.2 um den Transversal-Versatzbetrag V_DB_{y} = L_DB_{y}'+ Δ2' gegenüber dem ersten Detektorblock 22.1 versetzt angeordnet; dabei ist Δ2' = [10µm - 100µm] gewählt.

Wie im obigen Beispiel kann die Detektoranordnung aus Figur 8 natürlich noch um drei weitere Detektorgruppen ergänzt werden, über die drei weitere Teil-Inkrementalsignale erzeugbar sind. Aus der geeigneten Verschaltung der insgesamt vier Detektorgruppen lassen sich dann wiederum die beiden um 90° phasenversetzten Inkrementalsignale SIN, COS bilden.

Neben den konkret beschriebenen Ausführungsbeispielen existieren im Rahmen der vorliegenden Erfindung selbstverständlich noch weitere Ausgestaltungsmöglichkeiten für die erfindungsgemäße magnetische Positionsmesseinrichtung.

## Patentansprüche

1. Magnetische Positionsmesseinrichtung mit einem magnetischen Maßstab (10; 110) sowie einer in mindestens einer Messrichtung (x) relativ hierzu beweglichen Abtasteinheit (20; 120), wobei
- der magnetische Maßstab (10; 110) im gleichmäßigen Rastermaß P angeordnete Maßstabbereiche (11a, 11b; 111a, 111b) mit entgegengesetzt orientierter Magnetisierung besitzt, wobei das Rastermaß P die Ausdehnung eines Maßstabbereichs (11a, 11b; 111a, 111b) entlang der Messrichtung (x) angibt, und
- die Abtasteinheit (20; 120) mindestens eine erste Detektor-Elementarzelle (21.1) aufweist, die drei streifenförmige, magnetoresistive Detektorelemente (21.1a - 21.1c) umfasst, die in Messrichtung (x) beabstandet zueinander angeordnet sind, wobei die Längsrichtungen (y) der Detektorelemente (21.1a - 21.1c) jeweils senkrecht zur Messrichtung (x) orientiert sind,
**dadurch gekennzeichnet,**
- **dass** entlang der Messrichtung (x) benachbarte Detektorelemente (21.1a - 21.1c) in der ersten Detektor-Elementarzelle (21.1) einen Abstand Dx = P/12 zueinander aufweisen, und
- **dass** das mittlere Detektorelement (21.1b) entlang seiner Längsrichtung (y) eine Länge L_{b} aufweist, die größer ist als die Längen Lₐ, L_{c} der beiden äußeren Detektorelemente (21.1a, 21.1c), wobei die beiden äußeren Detektorelemente (21.1a, 21.1c) jeweils eine Detektorelement-Länge Lₐ = L_{c} = L_{b} / √3 aufweisen, und
- **dass** die Abtasteinheit (20; 120) mindestens einen ersten Detektorblock (22.1) aufweist, der aus der ersten Detektor-Elementarzelle (21.1) und einer zweiten Detektor-Elementarzelle (21.2) besteht, die identisch zur ersten Detektor-Elementarzelle (21.1) ausgebildet ist, wobei die zweite Detektor-Elementarzelle (21.2)
- entlang der Messrichtung (x) um den Messrichtungs-Versatzbetrag V_DEₓ = P/6 gegenüber der ersten Detektor-Elementarzelle (21.1) versetzt angeordnet ist, und
- senkrecht zur Messrichtung (x) um den Transversal-Versatzbetrag V_DE_{y} = L_{b} + Δ1 gegenüber der ersten Detektor-Elementarzelle (21.1) versetzt angeordnet ist, so dass der erste Detektorblock (22.1) entlang der Längsrichtung (y) der Detektorelemente (21.1a - 21.1c; 21.2a - 21.2c) eine Detektorblock-Länge L_DB_{y} = 2 • L_{b} + Δ1 besitzt, und wobei Δ1 = [10µm - 100µm] gewählt ist.

2. Magnetische Positionsmesseinrichtung nach Anspruch 1, **dadurch gekennzeichnet, dass** die Abtasteinheit (20; 120) ferner einen zweiten Detektorblock (22.2) aufweist, der identisch zum ersten Detektorblock (22.1) ausgebildet ist, wobei der erste und der zweite Detektorblock (22.1, 22.2) zusammen eine erste Detektorgruppe (23.1) bilden, und wobei der zweite Detektorblock (22.2)
- entlang der Messrichtung (x) um den Messrichtungs-Versatzbetrag V_DBₓ = P/22 gegenüber dem ersten Detektorblock (22.1) versetzt angeordnet ist, und
- senkrecht zur Messrichtung um den Transversal-Versatzbetrag V_DB_{y} = L_DB_{y} + Δ2 gegenüber dem ersten Detektorblock (22.1) versetzt angeordnet ist, und wobei Δ2 = [10µm - 100µm] gewählt ist.

3. Magnetische Positionsmesseinrichtung nach Anspruch 2, **dadurch gekennzeichnet, dass** die Detektorelemente der ersten Detektorgruppe (23.1) seriell miteinander verschaltet sind, so dass im Fall der Relativbewegung von Maßstab (10; 110) und Abtasteinheit (20; 120) ein erstes periodisches Teil-Inkrementalsignal (S_0) über die erste Detektorgruppe (23.1) erzeugbar ist.

4. Magnetische Positionsmesseinrichtung nach Anspruch 3, **dadurch gekennzeichnet, dass** die Abtasteinheit (20; 120) mindestens drei weitere Detektorgruppen (23.2, 23.3, 23.4) aufweist, die jeweils identisch zur ersten Detektorgruppe (23.1) ausgebildet sind, wobei
- eine zweite Detektorgruppe (23.2) entlang der Messrichtung (x) im Abstand Gₓ = P/4 beabstandet von der ersten Detektorgruppe (23.1) angeordnet ist, so dass im Fall der Relativbewegung von Maßstab (10; 110) und Abtasteinheit (20; 120) ein zweites periodisches Teil-Inkrementalsignal (S_90) über die zweite Detektorgruppe (23.2) erzeugbar ist, das um 90° phasenversetzt gegenüber dem ersten Teil-Inkrementalsignal (S_0) ist, und
- eine dritte Detektorgruppe (23.3) entlang der Messrichtung (x) im Abstand Gx = P/4 beabstandet von der zweiten Detektorgruppe (23.2) angeordnet ist, so dass im Fall der Relativbewegung von Maßstab (10; 110) und Abtasteinheit (20; 120) ein drittes periodisches Teil-Inkrementalsignal (S_180) über die dritte Detektorgruppe (23.3) erzeugbar ist, das um 90° phasenversetzt gegenüber dem zweiten Teil-Inkrementalsignal (S_90) ist und
- eine vierte Detektorgruppe (23.4) entlang der Messrichtung (x) im Abstand Gx = P/4 beabstandet von der dritten Detektorgruppe (23.3) angeordnet ist, so dass im Fall der Relativbewegung von Maßstab (10; 110) und Abtasteinheit (20; 120) ein viertes periodisches Teil-Inkrementalsignal (S_270) über die vierte Detektorgruppe (23.4) erzeugbar ist, das um 90° phasenversetzt gegenüber dem dritten Teil-Inkrementalsignal (S_180) ist

5. Magnetische Positionsmesseinrichtung nach Anspruch 4, **dadurch gekennzeichnet, dass**
- die erste und dritte Detektorgruppe (23.1, 23.3) derart miteinander verschaltet sind, dass aus dem ersten und dritten Teil-Inkrementalsignal (S_0, S_180) ein erstes periodisches Inkrementalsignal (SIN) erzeugbar ist, und
- die zweite und vierte Detektorgruppe (23.2, 23.4) derart miteinander verschaltet sind, dass aus dem zweiten und vierten Teil-Inkrementalsignal (S_90, S_270) ein zweites periodisches Inkrementalsignal (COS) erzeugbar ist, das gegenüber dem ersten Inkrementalsignal (SIN) um 90° phasenversetzt ist.

6. Magnetische Positionsmesseinrichtung mit einem magnetischen Maßstab (10; 110) sowie einer in mindestens einer Messrichtung (x) relativ hierzu beweglichen Abtasteinheit (20; 120), wobei
- der magnetische Maßstab (10; 110) im gleichmäßigen Rastermaß P angeordnete Maßstabbereiche (11a, 11b; 111a, 111b) mit entgegengesetzt orientierter Magnetisierung besitzt, wobei das Rastermaß P die Ausdehnung eines Maßstabbereichs (11a, 11b; 111a, 111b) entlang der Messrichtung (x) angibt, und
- die Abtasteinheit (20; 120) mindestens eine erste Detektor-Elementarzelle (21.1) aufweist, die drei streifenförmige, magnetoresistive Detektorelemente (21.1a - 21.1c) umfasst, die in Messrichtung (x) beabstandet zueinander angeordnet sind, wobei die Längsrichtungen (y) der Detektorelemente (21.1a - 21.1c) jeweils senkrecht zur Messrichtung (x) orientiert sind,
**dadurch gekennzeichnet,**
- **dass** die Abtasteinheit (20; 120) mindestens einen ersten Detektorblock (222.1) aufweist, der aus der ersten Detektor-Elementarzelle (221.1) und einer zweiten Detektor-Elementarzelle (221.2) besteht, wobei die zweite Detektor-Elementarzelle (221.2) senkrecht zur Messrichtung (x) um den Messrichtungs-Versatzbetrag V_DEₓ = P/6 versetzt gegenüber der ersten Detektor-Elementarzelle (222.1) angeordnet ist, und wobei ein Detektorelement (221.3) sowohl Bestandteil der ersten und der zweiten Detektor-Elementarzelle (221.1, 221.2) ist, so dass der erste Detektorblock (221) fünf Detektorelemente (221.1a, 221.1b, 221.3, 221.2a, 221.2b) umfasst, und
- die mittleren Detektorelemente (221.1b, 221.2b) der beiden Detektor-Elementarzellen (221.1, 221.2) jeweils die gleiche Länge L_{b} = L_{b}' aufweisen, und
- die äußersten Detektorelemente (221.1a, 221.2a) der beiden Detektor-Elementarzellen (221.1, 221.2) jeweils die gleiche Länge Lₐ = Lₐ' aufweisen, und
- das Detektorelement (221.3), welches sowohl Bestandteil der ersten und zweiten Detektor-Elementarzelle (221.1, 221.2) ist, entlang seiner Längsrichtung (y) eine Länge L₃ = 2 • Lₐ = 2 • L_{b}/√3 aufweist.

7. Magnetische Positionsmesseinrichtung nach Anspruch 6, **dadurch gekennzeichnet, dass** der erste Detektorblock (222.1) entlang der Längsrichtung (y) der Detektorelemente (221.1a, 221.1b, 221.3, 221.2a, 221.2b) eine Detektorblock-Länge L_DB_{y}'= 2 • L_{b} + Δ1' besitzt, und wobei Δ1' = [10µm - 100µm] gewählt ist.

8. Magnetische Positionsmesseinrichtung nach Anspruch 7, **dadurch gekennzeichnet, dass**
- das Detektorelement (221.3), welches sowohl Bestandteil der ersten und zweiten Detektor-Elementarzelle (221.1, 221.2) ist, symmetrisch zu einer mittigen Symmetrielinie (S) des ersten Detektorblocks (221.1) angeordnet ist, und
- die beiden weiteren Detektorelemente (221.1a, 221.1b) der ersten Detektor-Elementarzelle (221.1) im Bereich zwischen Δ1'/2 und L_DB_{y}'/2 beabstandet auf einer Seite der Symmetrielinie (S) angeordnet sind, und
- die beiden weiteren Detektorelemente (221.2a, 221.2b) der zweiten Detektor-Elementarzelle (221.2) im Bereich zwischen Δ1'/2 und L_DB_{y}'/2 auf der gegenüberliegenden Seite der Symmetrielinie (S) angeordnet sind.

9. Magnetische Positionsmesseinrichtung nach Anspruch 8, **dadurch gekennzeichnet, dass** die Abtasteinheit ferner einen zweiten Detektorblock (222.2) aufweist, der identisch zum ersten Detektorblock (222.1) ausgebildet ist, wobei der erste und der zweite Detektorblock (222.1, 222.2) zusammen eine erste Detektorgruppe (223.1) bilden und wobei der zweite Detektorblock (222.2)
- entlang der Messrichtung (x) um den Messrichtungs-Versatzbetrag V_DBₓ'= P/22 gegenüber dem ersten Detektorblock (222.1) versetzt angeordnet ist, und
- senkrecht zur Messrichtung (x) um den Transversal-Versatzbetrag V_DB_{y} = L_DB_{y}'+ Δ2' gegenüber dem ersten Detektorblock (222.1) versetzt angeordnet ist, und wobei Δ2' = [10µm - 100µm] gewählt ist.

10. Magnetische Positionsmesseinrichtung nach Anspruch 4 oder 9, **dadurch gekennzeichnet, dass** die Detektorelemente einer Detektorgruppe seriell miteinander verschaltet sind.

11. Magnetische Positionsmesseinrichtung nach mindestens einem der vorhergehenden Ansprüche, **dadurch gekennzeichnet, dass** die Detektorelemente als anisotrope magnetoresistive Sensoren ausgebildet sind.

## Claims

1. Magnetic position measuring device having a magnetic scale (10; 110) and a scanning unit (20; 120) movable relative thereto in at least one measuring direction (x),
- the magnetic scale (10; 110) having scale regions (11a, 11b; 111a, 111b) with oppositely oriented magnetization that are arranged with a uniform grid dimension P, the grid dimension P specifying the extent of the scale region (11a, 11b; 111a, 111b) along the measuring direction (x), and
- the scanning unit (20; 120) having at least one first detector elementary cell (21.1) that comprises three strip-shaped, magnetoresistive detector elements (21.1a - 21.1c) which are arranged at a distance from one another in the measuring direction (x), the longitudinal directions (y) of the detector elements (21.1a - 21.1c) each being oriented perpendicular to the measuring direction (x),
**characterized**
- **in that** detector elements (21.1a - 21.1c) in the first detector elementary cell (21.1) that are adjacent to one another in the measuring direction (x) have a distance Dₓ = P/12 from one another, and
- **in that** the central detector element (21.1b) has a length L_{b} in its longitudinal direction (y) that is greater than the length Lₐ, L_{c} of the two outer detector elements (21.1a, 21.1c), the two outer detector elements (21.1a, 21.1c) each having a detector element length Lₐ = L_{c} = L_{b}/√3, and
- **in that** the scanning unit (20; 120) has at least one first detector block (22.1) which consists of the first detector elementary cell (21.1) and a second detector elementary cell (21.2) which has an identical design to the first detector elementary cell (21.1), the second detector elementary cell (21.2)
- being arranged offset to the first detector elementary cell (21.1) in the measuring direction (x) by the measuring direction offset value V_DEₓ = P/6 and
- being arranged offset to the first detector elementary cell (21.1) perpendicular to the measuring direction (x) by the transverse offset value V_DE_{y} = L_{b} + Δ1 such that the first detector block (22.1) has a detector block length L_DB_{y} = 2.L_{b} + Δ1 in the longitudinal direction (y) of the detector elements (21.1a - 21.1c; 21.2a - 21.2c), and where Δ1 = [10 µm - 100 µm] has been chosen.

2. Magnetic position measuring device according to Claim 1, **characterized in that** the scanning unit (20; 120) further has a second detector block (22.2) which has an identical design to the first detector block (22.1), the first and the second detector block (22.1, 22.2) together forming a first detector group (23.1) and the second detector block (22.2)
- being arranged offset to the first detector block (22.1) in the measuring direction (x) by the measuring direction offset value V_DBₓ = P/22 and
- being arranged offset to the first detector block (22.1) perpendicular to the measuring direction by the transverse offset value V_DB_{y} = L_DB_{y} + Δ2, and where Δ2 = [10 µm - 100 µm] has been chosen.

3. Magnetic position measuring device according to Claim 2, **characterized in that** the detector elements of the first detector group (23.1) are interconnected in series such that a first periodic partial incremental signal (S_0) is generable by way of the first detector group (23.1) in the case of relative movement between scale (10; 110) and scanning unit (20; 120).

4. Magnetic position measuring device according to Claim 3, **characterized in that** the scanning unit (20; 120) has at least three further detector groups (23.2, 23.3, 23.4) which each have an identical design to the first detector group (23.1),
- a second detector group (23.2) being arranged at a distance from the first detector group (23.1) in the measuring direction (x) at a distance Gₓ = P/4 such that a second periodic partial incremental signal (S 90) which is 90° phase offset in relation to the first partial incremental signal (S_0) is generable by way of the second detector group (23.2) in the case of relative movement between scale (10; 110) and scanning unit (20; 120) and
- a third detector group (23.3) being arranged at a distance from the second detector group (23.2) in the measuring direction (x) at a distance Gₓ = P/4 such that a third periodic partial incremental signal (S_180) which is 90° phase offset in relation to the second partial incremental signal (S_90) is generable by way of the third detector group (23.3) in the case of relative movement between scale (10; 110) and scanning unit (20; 120) and
- a fourth detector group (23.4) being arranged at a distance from the third detector group (23.3) in the measuring direction (x) at a distance Gₓ = P/4 such that a fourth periodic partial incremental signal (S 270) which is 90° phase offset in relation to the third partial incremental signal (S_180) is generable by way of the fourth detector group (23.4) in the case of relative movement between scale (10; 110) and scanning unit (20; 120).

5. Magnetic position measuring device according to Claim 4, **characterized in that**
- the first and third detector groups (23.1, 23.3) are interconnected such that a first periodic incremental signal (SIN) is generable from the first and third partial incremental signals (S_0, S_180) and
- the second and fourth detector groups (23.2, 23.4) are interconnected such that a second periodic incremental signal (COS) which is 90° phase offset in relation to the first incremental signal (SIN) is generable from the second and fourth partial incremental signals (S_90, S_270).

6. Magnetic position measuring device having a magnetic scale (10; 110) and a scanning unit (20; 120) movable relative thereto in at least one measuring direction (x),
- the magnetic scale (10; 110) having scale regions (11a, 11b; 111a, 111b) with oppositely oriented magnetization that are arranged with a uniform grid dimension P, the grid dimension P specifying the extent of a scale region (11a, 11b; 111a, 111b) along the measuring direction (x), and
- the scanning unit (20; 120) having at least one first detector elementary cell (21.1) that comprises three strip-shaped, magnetoresistive detector elements (21.1a - 21.1c) which are arranged at a distance from one another in the measuring direction (x), the longitudinal directions (y) of the detector elements (21.1a - 21.1c) each being oriented perpendicular to the measuring direction (x),
**characterized**
- **in that** the scanning unit (20; 120) has at least one first detector block (222.1) consisting of the first detector elementary cell (221.1) and a second detector elementary cell (221.2), the second detector elementary cell (221.2) being arranged offset to the first detector elementary cell (222.1) perpendicular to the measuring direction (x) by the measuring direction offset value V_DEₓ = P/6 and a detector element (221.3) being a constituent part of both the first and the second detector elementary cell (221.1, 221.2) such that the first detector block (221) comprises five detector elements (221.1a, 221.1b, 221.3, 221.2a, 221.2b), and
- the central detector elements (221.1b, 221.2b) of the two detector elementary cells (221.1, 221.2) each have the same length L_{b} = L_{b}' and
- the outermost detector elements (221.1a, 221.2a) of the two detector elementary cells (221.1, 221.2) each have the same length Lₐ = Lₐ' and
- the detector element (221.3) which is a constituent part of both the first and the second detector elementary cell (221.1, 221.2) has a length L₃ = 2·Lₐ = 2·L_{b}/√3 in its longitudinal direction (y).

7. Magnetic position measuring device according to Claim 6, **characterized in that** the first detector block (222.1) has a detector block length L_DB_{y}' = 2·L_{b} + Δ1' in the longitudinal direction (y) of the detector elements (221.1a, 221.1b, 221.3, 221.2a, 221.2b) and where Δ1' = [10 µm - 100 µm] has been chosen.

8. Magnetic position measuring device according to Claim 7, **characterized in that**
- the detector element (221.3) which is a constituent part of both the first and the second detector elementary cell (221.1, 221.2) is arranged symmetrically with respect to a central line of symmetry (S) of the first detector block (221.1) and
- the two further detector elements (221.1a, 221.1b) of the first detector elementary cell (221.1) are arranged spaced apart in the range between Δ1'/2 and L_DB_{y}'/2 on one side of the line of symmetry (S) and
- the two further detector elements (221.2a, 221.2b) of the second detector elementary cell (221.2) are arranged in the range between Δ1'/2 and L_DB_{y}'/2 on the opposite side of the line of symmetry (S) .

9. Magnetic position measuring device according to Claim 8, **characterized in that** the scanning unit further has a second detector block (222.2) which has an identical design to the first detector block (222.1), the first and the second detector blocks (222.1, 222.2) together forming a first detector group (223.1) and the second detector block (222.2)
- being arranged offset to the first detector block (222.1) in the measuring direction (x) by the measuring direction offset value V_DBₓ' = P/22 and
- being arranged offset to the first detector block (222.1) perpendicular to the measuring direction (x) by the transverse offset value V_DB_{y} = L_DB_{y}'+ Δ2', and where Δ2' = [10 µm - 100 µm] has been chosen.

10. Magnetic position measuring device according to Claim 4 or 9, **characterized in that** the detector elements of a detector group are interconnected in series.

11. Magnetic position measuring device according to at least one of the preceding claims, **characterized in that** detector elements are designed as anisotropic magnetoresistive sensors.

## Revendications

1. Dispositif de mesure de position magnétique, comprenant une échelle graduée magnétique (10; 110) ainsi qu'une unité de palpage (20; 120) mobile par rapport à celle-ci dans au moins une direction de mesure (x),
- l'échelle graduée magnétique (10 ; 110) possédant des zones d'échelle graduée (11a, 11b; 111a, 111b) disposées selon un pas de grille P régulier et ayant une magnétisation orientée en opposé, le pas de grille P indiquant l'extension d'une zone d'échelle graduée (11a, 11b; 111a, 111b) le long de la direction de mesure (x), et
- l'unité de palpage (20 ; 120) possédant au moins une première cellule élémentaire de détecteur (21.1), laquelle comporte trois éléments détecteurs (21.1a - 21.1c) magnétorésistifs en forme de bande, qui sont disposés espacés les uns des autres dans la direction de mesure (x), les directions longitudinales (y) des éléments détecteurs (21.1a - 21.1c) étant respectivement orientées perpendiculairement à la direction de mesure (x),
**caractérisé en ce**
- **que** les éléments détecteurs (21.1a - 21.1c) voisins le long de la direction de mesure (x) dans la première cellule élémentaire de détecteur (21.1) présentant un écart Dₓ = P/12 les uns par rapport aux autres, et
- **que** l'élément détecteur central (21.1b) présente le long de sa direction longitudinale (y) une longueur L_{b} qui est supérieure aux longueurs Lₐ, L_{c} des deux éléments détecteurs extérieurs (21.1a, 21.1c), les deux éléments détecteurs extérieurs (21.1a, 21.1c) présentant respectivement une longueur d'élément détecteur Lₐ = L_{c} = L_{b}/√3, et
- **que** l'unité de palpage (20 ; 120) possède au moins un premier bloc détecteur (22.1), lequel se compose de la première cellule élémentaire de détecteur (21.1) et d'une deuxième cellule élémentaire de détecteur (21.2), qui est de configuration identique à la première cellule élémentaire de détecteur (21.1), la deuxième cellule élémentaire de détecteur (21.2)
- étant disposée dans la direction de mesure (x) décalée du montant de décalage de direction de mesure V_DEₓ = P/6 par rapport à la première cellule élémentaire de détecteur (21.1), et
- étant disposée perpendiculairement à la direction de mesure (x) décalée du montant de décalage transversal V_DE_{y} = L_{b} + Δ1 par rapport à la première cellule élémentaire de détecteur (21.1), de sorte que le premier bloc détecteur (22.1) possède, le long de la direction longitudinale (y) des éléments détecteurs (21.1a - 21.1c ; 21.2a - 21.2c), une longueur de bloc détecteur L_DB_{y} = 2 • L_{b} + Δ1, et Δ1 étant choisi égal à [10 µm - 100 µm].

2. Dispositif de mesure de position magnétique selon la revendication 1, **caractérisé en ce que** l'unité de palpage (20 ; 120) possède en outre un deuxième bloc détecteur (22.2), lequel est de configuration identique au premier bloc détecteur (22.1), le premier et le deuxième bloc détecteur (21.1, 22.2) formant ensemble un premier groupe détecteur (23.1) et le deuxième bloc détecteur (22.2)
- étant disposé dans la direction de mesure (x) décalée du montant de décalage de direction de mesure V_DBₓ = P/22 par rapport au premier bloc détecteur (22.1), et
- étant disposé perpendiculairement à la direction de mesure décalée du montant de décalage transversal V_DB_{y} = L_DB_{y} + Δ2 par rapport au premier bloc détecteur (22.1), et Δ2 étant choisi égal à [10 µm - 100 µm].

3. Dispositif de mesure de position magnétique selon la revendication 2, **caractérisé en ce que** les éléments détecteurs du premier groupe détecteur (23.1) sont branchés en série les uns avec les autres, de sorte que dans le cas du mouvement relatif de l'échelle graduée (10 ; 110) et de l'unité de palpage (20 ; 120), un premier signal incrémental partiel (S_0) périodique peut être généré par le biais du premier groupe détecteur (23.1).

4. Dispositif de mesure de position magnétique selon la revendication 3, **caractérisé en ce que** l'unité de palpage (20; 120) possède au moins trois groupes détecteurs (23.2, 23.3, 23.4) supplémentaires, lesquels sont respectivement de configuration identique au premier groupe détecteur (23.1),
- un deuxième groupe détecteur (23.2) étant disposé le long de la direction de mesure (x) espacé de l'écart Gₓ = P/4 du premier groupe détecteur (23.1), de sorte que dans le cas du mouvement relatif de l'échelle graduée (10; 110) et de l'unité de palpage (20; 120), un deuxième signal incrémental partiel (S_90) périodique peut être généré par le biais du deuxième groupe détecteur (23.2), lequel est déphasé de 90° par rapport au premier signal incrémental partiel (S_0), et
- un troisième groupe détecteur (23.3) étant disposé le long de la direction de mesure (x) espacé de l'écart Gₓ = P/4 du deuxième groupe détecteur (23.2), de sorte que dans le cas du mouvement relatif de l'échelle graduée (10; 110) et de l'unité de palpage (20; 120), un troisième signal incrémental partiel (S_180) périodique peut être généré par le biais du troisième groupe détecteur (23.3), lequel est déphasé de 90° par rapport au deuxième signal incrémental partiel (S_90), et
- un quatrième groupe détecteur (23.4) étant disposé le long de la direction de mesure (x) espacé de l'écart Gₓ = P/4 du troisième groupe détecteur (23.3), de sorte que dans le cas du mouvement relatif de l'échelle graduée (10; 110) et de l'unité de palpage (20; 120), un quatrième signal incrémental partiel (S_270) périodique peut être généré par le biais du quatrième groupe détecteur (23.4), lequel est déphasé de 90° par rapport au troisième signal incrémental partiel (S_180).

5. Dispositif de mesure de position magnétique selon la revendication 4, **caractérisé en ce que**
- les premier et troisième groupes détecteurs (23.1, 23.3) sont connectés l'un à l'autre de telle sorte qu'un premier signal incrémental (SIN) périodique peut être généré à partir des premier et troisième signaux incrémentaux partiels (S_0, S_180), et
- les deuxième et quatrième groupes détecteurs (23.2, 23.4) sont connectés l'un à l'autre de telle sorte qu'un deuxième signal incrémental (COS) périodique peut être généré à partir des deuxième et quatrième signaux incrémentaux partiels (S_90, S_270), lequel est déphasé de 90° par rapport au premier signal incrémental (SIN).

6. Dispositif de mesure de position magnétique, comprenant une échelle graduée magnétique (10; 110) ainsi qu'une unité de palpage (20; 120) mobile par rapport à celle-ci dans au moins une direction de mesure (x),
- l'échelle graduée magnétique (10 ; 110) possédant des zones d'échelle graduée (11a, 11b; 111a, 111b) disposées selon un pas de grille P régulier et ayant une magnétisation orientée en opposé, le pas de grille P indiquant l'extension d'une zone d'échelle graduée (11a, 11b ; 111a, 111b) le long de la direction de mesure (x), et
- l'unité de palpage (20 ; 120) possédant au moins une première cellule élémentaire de détecteur (21.1), laquelle comporte trois éléments détecteurs (21.1a - 21.1c) magnétorésistifs en forme de bande, qui sont disposés espacés les uns des autres dans la direction de mesure (x), les directions longitudinales (y) des éléments détecteurs (21.1a - 21.1c) étant respectivement orientées perpendiculairement à la direction de mesure (x),
**caractérisé en ce que**
- l'unité de palpage (20 ; 120) possède au moins un premier bloc détecteur (222.1), lequel se compose de la première cellule élémentaire de détecteur (221.1) et d'une deuxième cellule élémentaire de détecteur (221.2), la deuxième cellule élémentaire de détecteur (221.2) étant disposée perpendiculairement à la direction de mesure (x) décalée du montant de décalage de direction de mesure V_DEₓ = P/6 par rapport à la première cellule élémentaire de détecteur (221.1), et un élément détecteur (221.3) étant un élément constitutif à la fois de la première et de la deuxième cellule élémentaire de détecteur (221.1, 221.2), de sorte que le premier bloc détecteur (222.1) comporte cinq éléments détecteurs (221.1a, 221.1b, 221.3, 221.2a, 221.2b), et
- les éléments détecteurs centraux (221.1b, 221.2b) des deux cellules élémentaires de détecteur (221.1, 221.2) présentent respectivement la même longueur L_{b} = L_{b}', et
- les éléments détecteurs extérieurs (221.1a, 221.2a) des deux cellules élémentaires de détecteur (221.1, 221.2) présentent respectivement la même longueur Lₐ = Lₐ', et
- l'élément détecteur (221.3) qui est un élément constitutif à la fois de la première et de la deuxième cellule élémentaire de détecteur (221.1, 221.2) présente une longueur L₃ = 2 • Lₐ = 2 • L_{b}/√3 le long de sa direction longitudinale (y).

7. Dispositif de mesure de position magnétique selon la revendication 6, **caractérisé en ce que** le premier bloc détecteur (222.1) possède le long de la direction longitudinale (y) des éléments détecteurs (221.1a, 221.1b, 221.3, 221.2a, 221.2b) une longueur de bloc détecteur L_DB_{y}'= 2 • L_{b} + Δ1', et Δ1' étant choisi égal à [10 µm - 100 µm].

8. Dispositif de mesure de position magnétique selon la revendication 7, **caractérisé en ce que**
- l'élément détecteur (221.3) qui est un élément constitutif à la fois de la première et de la deuxième cellule élémentaire de détecteur (221.1, 221.2) est disposé symétriquement par rapport à une ligne de symétrie centrale (S) du premier bloc détecteur (222.1), et
- les deux autres éléments détecteurs (221.1a, 221.1b) de la première cellule élémentaire de détecteur (221.1) sont disposés d'un côté de la ligne de symétrie (S) espacés d'un écart dans la plage entre Δ1'/2 et L_DB_{y}'/2, et
- les deux autres éléments détecteurs (221.2a, 221.2b) de la deuxième cellule élémentaire de détecteur (221.2) sont disposés sur le côté opposé de la ligne de symétrie (S) dans la plage entre Δ1'/2 et L_DB_{y}'/2.

9. Dispositif de mesure de position magnétique selon la revendication 8, **caractérisé en ce que** l'unité de palpage possède en outre un deuxième bloc détecteur (222.2), lequel est de configuration identique au premier bloc détecteur (222.1), le premier et le deuxième bloc détecteur (222.1, 222.2) formant ensemble un premier groupe détecteur (223.1) et le deuxième bloc détecteur (222.2)
- étant disposé dans la direction de mesure (x) décalé du montant de décalage de direction de mesure V_DBₓ' = P/22 par rapport au premier bloc détecteur (222.1), et
- étant disposé perpendiculairement à la direction de mesure (x) décalée du montant de décalage transversal V_DB_{y} = L_DB_{y}'+ Δ2' par rapport au premier bloc détecteur (222.1), et Δ2' étant choisi égal à [10 µm - 100 µm].

10. Dispositif de mesure de position magnétique selon la revendication 4 ou 8, **caractérisé en ce que** les éléments détecteurs d'un groupe détecteur sont branchés en série les uns avec les autres.

11. Dispositif de mesure de position magnétique selon au moins l'une des revendications précédentes, **caractérisé en ce que** les éléments détecteurs sont réalisés sous la forme de capteurs magnétorésistifs anisotropes.
